# EUROPÄISCHE PATENTSCHRIFT

(11) **EP 0 421 095 B1**
(45) Veröffentlichungstag und Bekanntmachung des Hinweises auf die Patenterteilung: **03.05.1995**
(21) Anmeldenummer: 90115491.4
(22) Anmeldetag: 13.08.1990
(51) Int. Cl.: H05K 7/14

(54) **Gerät zum Erfassen und Verarbeiten von elektrischen Signalen**
Apparatus for sensing and processing of electrical signals
Appareil pour saisir et traiter des signaux électriques

(30) Priorität: 06.10.1989 DE 3933320
(43) Veröffentlichungstag der Anmeldung: 10.04.1991
(73) Patentinhaber: SENSYCON GESELLSCHAFT FÜR INDUSTRIELLE SENSORSYSTEME UND PROZESSLEITTECHNIK MBH, 30179 Hannover (DE)
(72) Erfinder: Friedemann, Dieter, D-3006 Burgwedel 1 (DE); Bruhn, Arno, D-3000 Hannover 51 (DE); Michel, Helmut, D-3000 Hannover 51 (DE); Riedemann, Manfred, D-3000 Hannover 51 (DE); Saager, Dieter, D-3013 Barsinghausen 1 (DE)
(74) Vertreter: Presting, Hans-Joachim, Dipl.-Ing.

(56) Entgegenhaltungen:
- DE-A- 3 302 223
- DE-A- 3 902 849
- FR-A- 2 561 410
- FR-A- 2 567 304

## Beschreibung

Die Erfindung bezieht sich auf ein Gerät zum Erfassen und Verarbeiten von elektrischen Signalen, mit einem Gerätegehäuse, das in zur Frontseite hin offenen Einschubkammern unterteilt ist, wobei in einer Einschubkammer ein eine elektronische Reglereinheit enthaltender Reglereinschub und in eine zweite Einschubkammer ein ein Netzteil enthaltender Netzteileinschub angeordnet ist, wobei die Reglereinheit und das Netzteil mittels Leitungen sowohl untereinander als auch mit Anschlußkontakten für externe Anschlüsse verbunden sind.

Bei derartigen Geräten besteht das Problem, daß zum Zwecke des Austausches eine Reglereinheit oder eines Netzteiles aufgrund des Aufbaus das Gerätes eine Unterbrechung des Betriebs erfolgen muß bis der Austausch durchgeführt ist.

Aufgabe der Erfindung ist es daher, ein Gerät der eingangs genannten Art zu schaffen, das einen Austausch einer Reglereinheit ohne Betriebsunterbrechung ermöglicht.

Diese Aufgabe wird erfindungsgemäß dadurch gelöst, daß in weiteren zur Frontseite des Gerätegehäuses offenen Einschubkammern ein Reglereinschub mit einer zur ersten Reglereinheit identischen zweiten elektronischen Reglereinheit und ein Netzteileinschub mit einem zum ersten Netzteil identischen zweiten Netzteil angeordnet sind, die mittels Leitungen sowohl untereinander als auch mit Anschlußkontakten für externe Anschlüsse verbunden sind, daß durch das erste Netzteil die erste Reglereinheit und durch das zweite Netzteil die zweite Reglereinheit energieversorgbar ist, daß beiden Reglereinheiten gleichzeitig parallel von außen über die Leitungen die gleichen Eingangssignale zugeleitet und von beiden Reglereinheiten synchron verarbeitet werden und daß abhängig von der Signalverarbeitung und/oder dem Status der Reglereinheiten ausschließlich von einer der Reglereinheiten Ausgangssignale erzeugt werden. Bei diesem Aufbau verarbeiten beide Reglereinheiten separat und synchron die Eingangssignale und halten beide an ihrem Ausgang die Ausgangsinformation abrufbereit, wobei aber nur von einer Reglereinheit die Ausgangsinformation tatsächlich abrufbar ist. Von welcher der Reglereinheiten die Ausgangsinformationen abgerufen werden, hängt bei intakten Reglereinheiten z.B. davon ab, an wessen Ausgang nach einer Inbetriebnahme des Geräts zuerst die Ausgangsinformation ansteht.

Bei einem Defekt einer Reglereinheit leitet diese eine entsprechende Information der anderen Reglereinheit zu, so daß dann an deren Ausgang die Ausgangsinformation abrufbar ist.

Nach demselben Prinzip arbeitet das Gerät auch bei Abwesenheit einer der Reglereinheiten, da dann die vorhandene Reglereinheit die Abwesenheit der anderen Reglereinheit als einen Defekt ansieht und an ihrem Ausgang die Ausgangsinformation abrufbereit hält.

Vorzugsweise ist jeder Reglereinheit eines der Netzteile zugeordnet. Damit ist das Gerät auch voll funktionsfähig, wenn nur eine Reglereinheit und das ihr zugeordnete Netzteil vorhanden sind.

Sind Reglereinheiten und Netzteile mit einer im Gerategehause angeordneten Verbindungsleiterplatte verbindbar auf der die Leitungen ausgebildet und die Anschlußkontakte angeordnet sind, so können auf einfache Art die externen Verbindungen, wie Datenkabel und Netzanschluß über die Anschlußkontakte aufrechterhalten bleiben, wenn eine Reglereinheit oder ein Netzteil dem Gerät entnommen oder an das Gerät angeschlossen werden.
Vorzugsweise überdeckt die Verbindungsleiterplatte die der Frontseite gegenüberliegende Bodenseite der Einschubkammern und weist mit den Leitungen verbundene Gegensteckkontakte auf, in die an der Rückseite der Netzteile Einschübe und/oder der Reglereinschübe angeordnete Steckkontakte einführbar sind, so daß durch einfaches Entnehmen oder Einführen der Regler- bzw. Netzteileinschube eine vollständige Montage bzw. Demontage erfolgt. Dies ist auch während des Betriebs möglich, wenn das Gerät unter Spannung steht.

Ein einfacher Aufbau und eine leichte Zugänglichkeit zu den Anschlußkontakten ergibt sich dadurch, daß sich die Verbindungsleiterplatte über den Bereich der Einschubkammern hinaus in den Bereich einer Kontaktierungskammer erstreckt, die in dem Gerätegehäuse seitlich neben den Einschubkammern angeordnet ist und in deren Bereich die Anschlußkontakte für externe Anschlüsse auf der Verbindungsleiterplatte angeordnet sind.

Vorzugsweise sind die Anschlußkontakte Steckkontakte.

Ist die frontseitige Öffnung der Kontaktierungskammer durch eine Verschlußplatte verschließbar, wobei die Verschlußplatte um eine sich entlang einer Seitenkante der Öffnung erstreckende Schwenkachse schwenkbar ist, so ist ein direkter Zugriff zu den Anschlußkontakten möglich.

Weist der Boden und/oder der Deckel des Gerätegehäuses im Bereich der Kontaktierungskammer eine Kabeldurchführöffnung auf, so können die Kabel innerhalb des Gerätegehäuses zu einem weiteren über oder unter dem Gerät angeordneten Gerät geführt werden.

Dies ist auch bei einem seitlich an die Kontaktierungskammer anschließend angeordneten weiteren Gerät möglich, wenn die den Einschubkammern abgewandte Seitenwand der Kontaktierungskammer eine Kabeldurchführöffnung aufweist, wobei vorzugsweise die Kabeldurchführöffnung im oberen und/oder unteren Bereich der Seitenwand angeordnet ist.

Zum einfachen Verschließen der Einschubkammern können die frontseitigen Öffnungen der Einschubkammern durch Frontplatten der Reglereinschübe und/oder Netzteileinschübe verschließbar sein.

Zur Abfuhr der von den Wärme erzeugenden Bauteilen von Netzteil und Reglereinheit produzierten Wärme kann im Gerätegehäuse unter den Einschubkammern eine Lüfterkammer ausgebildet sein, in der eine Lüftereinheit ist, durch die von außen angesaugte Luft über Verbindungsöffnungen in die Einschubkammern blasbar ist, wozu vorzugsweise die Einschubkammern durch ein Lochblech von der Lüfterkammer getrennt sind. Zur einfachen separaten Montage und Demontage kann die Lüftereinheit eine Einschubeinheit sein, die in die Lüfterkammer einschiebbar ist.

Zur gleichmäßigen Durchströmung aller Bereiche der Einschubkammern mit Kühlluft kann die Lüftereinheit mehrere über die Ebene der Lüfterkammer verteilt angeordnete Lüfter besitzen, die vorzugsweise auf einer gemeinsamen Trägerplatte angeordnet sind.

In einer zusätzlichen Funktion kann die Trägerplatte eine mit der Verbindungsleiterplatte kontaktierbare Leiterplatte sein, auf der ggfs. elektronische Bauteile angeordnet sind.

Eine leichte Einbaubarkeit mit exakter Positionierung wird dadurch erreicht, daß die Trägerplatte in Einschubführungen der Lüfterkammer einführbar ist.

Damit die Einschubkammern nur von gereinigter Luft durchströmt werden, kann in der Lüfterkammer auf der den Einschubkammern entgegengesetzten Seite der Lüftereinheit eine Filtereinheit angeordnet sein, über die von der Lüftereinheit Außenluft ansaugbar ist.

Die Kombination des Einblasens von gereinigter Luft in die Einschubkammern hat den Vorteil, daß keine Schmutzteilchen zu den dort angeordneten elektronischen Bauteilen gelangen und Defekte verursachen können. Der durch die eingeblasene Luft erzeugte gering höhere Innendruck im Gerätegehäuse vermeidet, daß an irgendwelchen großen oder kleinen Öffnungen und Spalten im Gerätegehäuse Verschmutzungen in das Gerätegehäuse eintreten können.

In einem einfachen Aufbau kann die Filtereinheit einen starren Träger aufweisen, der in den den Lüftern gegenüberliegenden Bereichen luftdurchlässige Filterbereiche aufweist, wobei zur einfachen Montage und Demontage, wie z.B. bei einem Filterwechsel, der Träger in Führungen geführt in die Lüfterkammer einfuhrbar sein kann.

Zum Schutz gegen Beschädigung und zur Vermeidung ungereinigten Lufteintritts hinter der Filtereinheit kann die frontseitige Öffnung der Lüfterkammer von einem Deckel verschließbar sein. Zum Lufteintritt kann der Boden der Lüfterkammer durch ein Lochblech gebildet sein. Ist auch der Deckel des Gerätegehäuses im Bereich der Einschubkammern durch ein Lochblech gebildet, so können mehrere übereinander angeordnete gleiche Geräte im Bereich ihrer Einschubkammern einen von Kühlluft durchströmbaren Kamin bilden.

In einem Reglereinschub kann eine erste eine zentrale Rechnereinheit tragende Rechnerplatine anordenbar sein, die Steckkontakteinrichtungen aufweist, auf die weitere Leiterplatinen elektrisch verbindend aufsteckbar sind, wobei die weiteren Leiterplatinen z.B. Ein- und Ausgangsmodule sein können.

Zur bedarfsweisen Funktionserweiterung kann in dem Reglereinschub eine zweite eine zentrale Rechnereinheit tragende Erweiterungsrechnerplatine anordenbar sein, die Steckkontakteinrichtungen aufweist, auf die weitere Leiterplatinen elektrisch verbindend aufsteckbar sind.

Dabei ergibt sich eine leichte Austauschbarkeit, wenn der Reglereinschub Einschubführungen aufweist, in die die Rechnerplatine und/oder die Erweiterungsrechnerplatine einführbar sind.

Auf einfache Weise können die Rechnerplatine und die Erweiterungsrechnerplatine mittels eines Kabels leitend verbindbar sein, wobei vorzugsweise das Kabel ein Flachkabel ist.

Sind die Rechnerplatine und die Erweiterungsrechnerplatine in einem Abstand etwa parallel zueinander im Reglereinschub anordenbar, wobei die Leiterplatinen von Rechnerplatine und Erweiterungsrechnerplatine etwa rechtwinklig wegragend zueinander gerichtet anordenbar sind, so ergibt sich nicht nur ein geringer erforderlicher Bauraum sondern auch eine gute Durchströmbarkeit mit Kühlluft.

Dazu ist weiterhin vorzugsweise der Reglereinschub in seinem Boden- und Deckelbereich offen.

Um sofort den Defekt einer Reglereinheit feststellen zu können, kann die Reglereinheit eine Selbsttestschaltung aufweisen, durch die abhängig vom Status der Reglereinheit ein Fehlersignal bzw. ein Gutsignal erzeugbar ist.

Zur Vermeidung der Abgabe falscher Ausgangsinformationen kann durch ein Fehlersignal einer Reglereinheit der Ausgang dieser Reglereinheit sperrbar sein.

Damit im Falle eines Defekts einer Reglereinheit keine Betriebsunterbrechung erfolgt, kann durch ein Fehlersignal einer Reglereinheit in der anderen Reglereinheit eine Aktivierung auslösbar sein, durch die der Ausgang der anderen Reglereinheit aktivierbar ist, so daß unterbrechungslos von der anderen Reglereinheit eine einwandfreie Ausgangsinformation zur Verfügung steht.

Ein Ausführungsbeispiel der Erfindung ist in der Zeichnung dargestellt und wird im folgenden näher beschrieben. Es zeigen
- Figur 1: eine Ansicht eines geschlossenen Gerätes zum Erfassen und Verarbeiten von elektrischen Signalen,
- Figur 2: eine Ansicht des geöffneten Gerätes nach Figur 1,
- Figur 3: eine teilweise Seitenansicht von rechts des Geräts nach Figur 1 im Teilschnitt,
- Figur 4: ein Reglereinschub des Geräts nach Figur 1 im Teilschnitt,
- Figur 5: eine Seitenansicht des Reglereinschubs nach Figur 4,
- Figur 6: eine Lüftereinheit eines Geräts nach Figur 1 in der Draufsicht,
- Figur 7: die Lüftereinheit nach Figur 6 in der Seitenansicht,
- Figur 8: eine Filtereinheit des Geräts nach Figur 1 in der Draufsicht,
- Figur 9: die Filtereinheit nach Figur 8 in der Seitenansicht,
- Figur 10: ein Netzteileinschub des Geräts in der Vorderansicht,
- Figur 11: der Netzteileinschub nach Figur 10 in der Seitenansicht,
- Figur 12: ein Blockschaltbild zweiter Reglereinheiten und der Verbindungsleiterplatte des Geräts nach Figur 1.

Das in den Zeichnungen dargestellte Gerät besitzt ein Gerätegehäuse 1, das in zwei Einschubkammern 2 zur Aufnahme zweier Reglereinschübe 3 und links daneben zwei übereinander angeordnete Einschubkammern 4 zur Aufnahme zweier Netzteileinschübe unterteilt ist.

Unter den Einschubkammern 2 und 4 ist im Gerätegehäuse 1 eine Lüfterkammer 6 abgeteilt, die sich über die gesamte Breite der Einschubkammern 2 und 4 erstreckt. Rechts neben der Einschubkammer 2 und der Lufterkammer 6 ist im Gerätegehäuse 1 eine Kontaktierungskammer 7 abgeteilt.

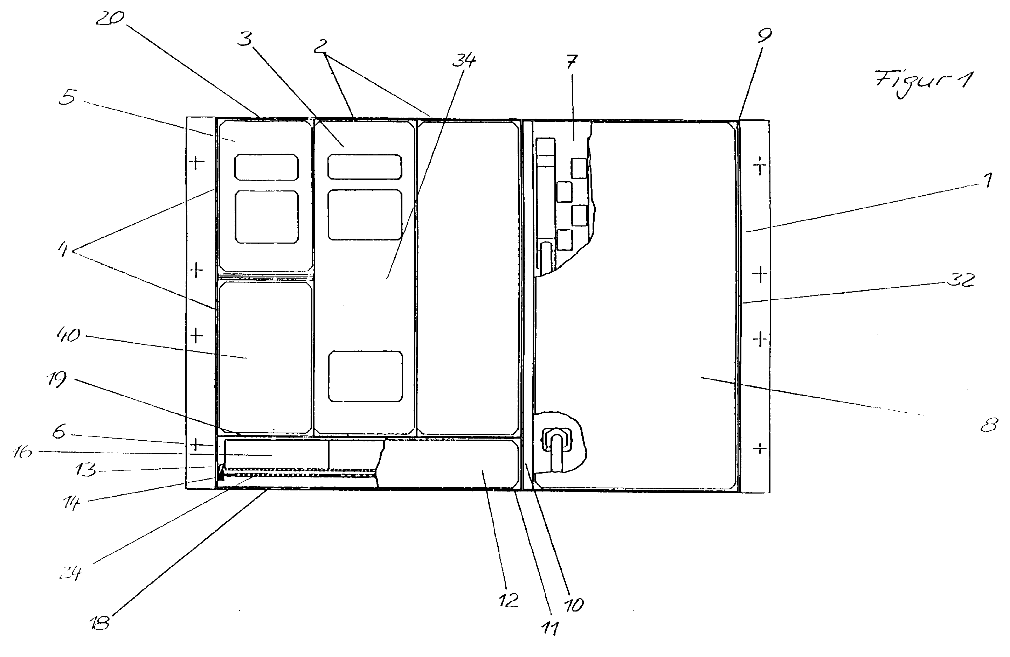

Wie in Figur 1 zu sehen ist in der oberen Einschubkammer 4 ein Netzteileinschub 5 und in der linken Einschubkammer 2 ein Reglereinschub 3 angeordnet, während die untere Einschubkammer 4 und die rechte Einschubkammer 2 nur durch Blenden verschlossen und leer sind.

Die Kontaktierungskammer 7 ist durch eine Verschlußplatte 8 verschlossen, die um eine sich entlang der linken Seitenkante der frontseitigen Öffnung 9 der Kontaktierungskammer 7 erstreckende Schwenkachse 10 zum Öffnen und Schließen schwenkbar ist.

Die frontseitige Öffnung der Lüfterkammer 6 ist durch einen Deckel 12 ebenfalls verschließbar.

In der Lüfterkammer 6 sind in zwei Ebenen übereinander Einschubführungen 13 und Führungen 14 angeordnet, wobei in die in der oberen Ebene angeordneten Einschubführungen 13 eine Trägerplatte 15 einer Lüftereinheit 16 und in die in der unteren Ebene angeordneten Führungen 14 der Träger 17 einer Filtereinheit 24 von der Frontseite her einschiebbar sind.

Sowohl der Boden 18 der Lüfterkammer 6 als auch die Trennwand 19 zwischen der Lüfterkammer 6 und Einschubkammern 2 und 4 sind als Lochbleche ausgebildet.

Desgleichen ist der Deckel 20 des Gerätegehäuses 1 im Bereich der Einschubkammern 2 und 4 als Lochblech ausgebildet.

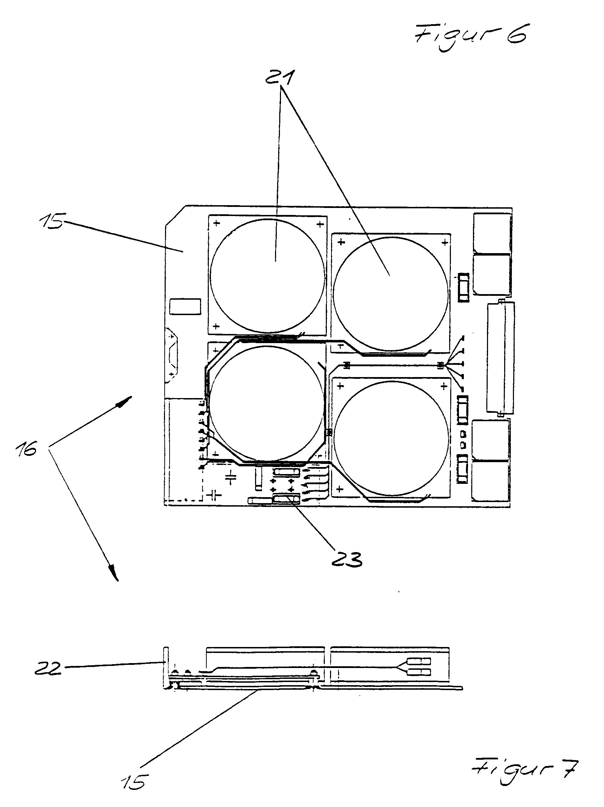

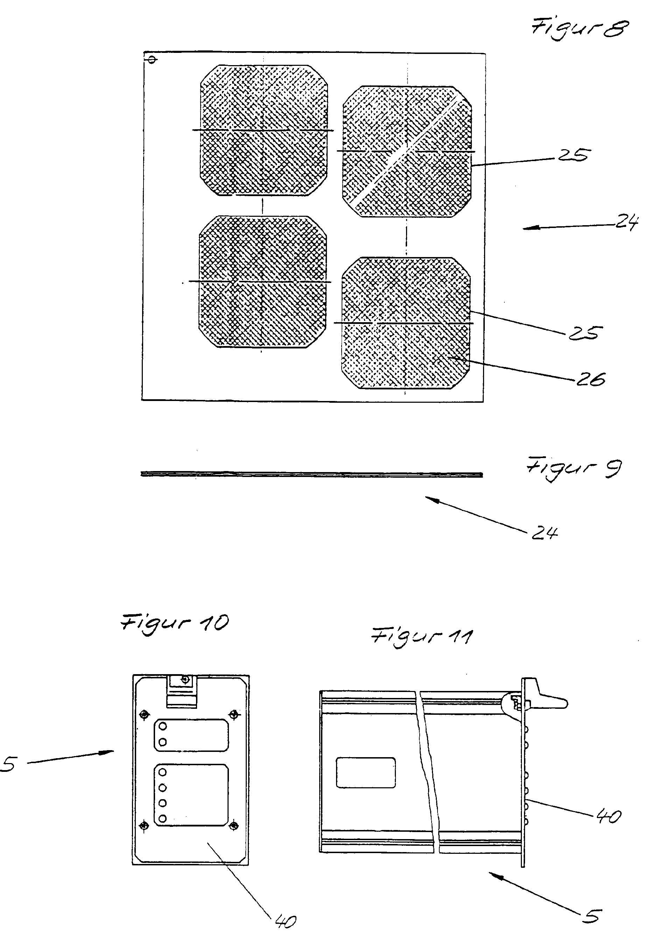

Wie in den Figuren 6 und 7 näher dargestellt, sind auf der Trägerplatte 15 verteilt vier Lüfter 21 angeordnet, durch die über die Filtereinheit 24 Außenluft angesaugt und in die Einschubkammern 2 und 4 geblasen wird und um durch den Deckel 20 wieder auszutreten.

An der Frontseite der gleichzeitig als Leiterplatte ausgebildeten Trägerplatte 15 ist eine senkrechte Schutzblende 22 zum Schutz von auf der Trägerplatte 15 befindlichen elektronischen Bauteilen 23 gegen Beschädigung angeordnet.

Die Filtereinheit 24, die in den Figuren 8 und 9 näher dargestellt ist, besteht aus einem starren Träger 17, der in den den Lüftern 21 gegenüberliegenden Bereichen Aussparungen 25 aufweist, die durch Filtermatten 26 abgedeckt sind und luftdurchlässige Filterbereiche bilden.

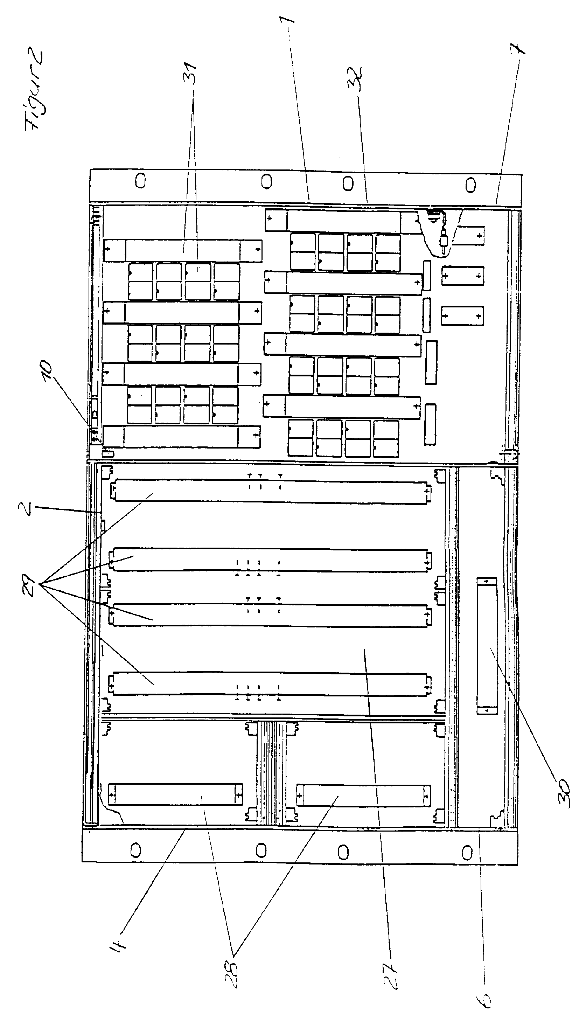

Wie insbesondere in Figur 2 dargestellt, ist im Bereich der der Frontseite des Gerätegehäuses 1 gegenüberliegenden Bodenseite eine sich über die Einschubkammern 2 und 4, die Lüfterkammer 6 und die Kontaktierungskammer 7 erstreckende Verbindungsleiterplatte 27 angeordnet.

Im Bereich der Einschubkammern 4 sind auf der Verbindungsleiterplatte 27 Gegensteckkontakte 28 und im Bereich der Einschubkammer 2 Gegensteckkontakte 29 angeordnet, die mit entsprechenden Steckkontakten an den Rückseiten der Netzteileinschübe 5 und Reglereinschübe 3 bei Einführen dieser Einschübe in ihre Einschubkammern elektrisch leitend verbindbar sind.

Desgleichen ist im Bereich der Lüfterkammer 6 ein Gegensteckkontakt 30 zur elektrisch leitenden Verbindung der Lüftereinheit 16 mit der Verbindungsleiterplatte 27 angeordnet.

Über die nicht dargestellten Leiterbahnen der Verbindungsleiterplatte 27 sind die verschiedenen Einheiten des Gerätes untereinander sowie mit als Steckkontakte ausgebildeten Anschlußkontakten 31 verbunden, die im Bereich der Kontaktierungskammer 7 angeordnet sind und mit denen externe Anschlüsse verbindbar sind, die über elektrische Leitungen zu externen Einheiten, wie z.B. Netzanschluß, Steuer- und Sensoreinheiten führen.

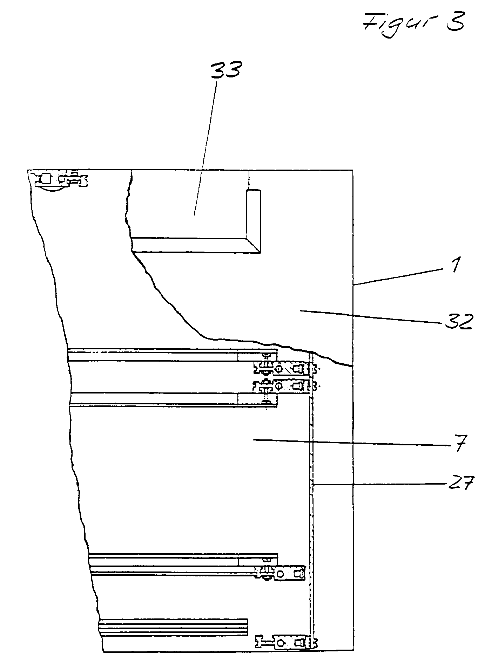

Da, wie insbesondere in Figur 3 zu erkennen, der Boden und der Deckel des Gerätegehäuses 1 im Bereich der Kontaktierungskammer 7 offen sind, können die elektrischen Leitungen von den Anschlußkontakten 31 direkt zu senkrecht über oder unter dem Gerät angeordneten weiteren Geräten geführt werden.

Eine in der im oberen Bereich der freien Seitenwand 32 der Kontaktierungskammer 7 ausgebildete Kabeldurchführöffnung 33 ermöglicht auch das seitliche Herausführen der Leitungen.

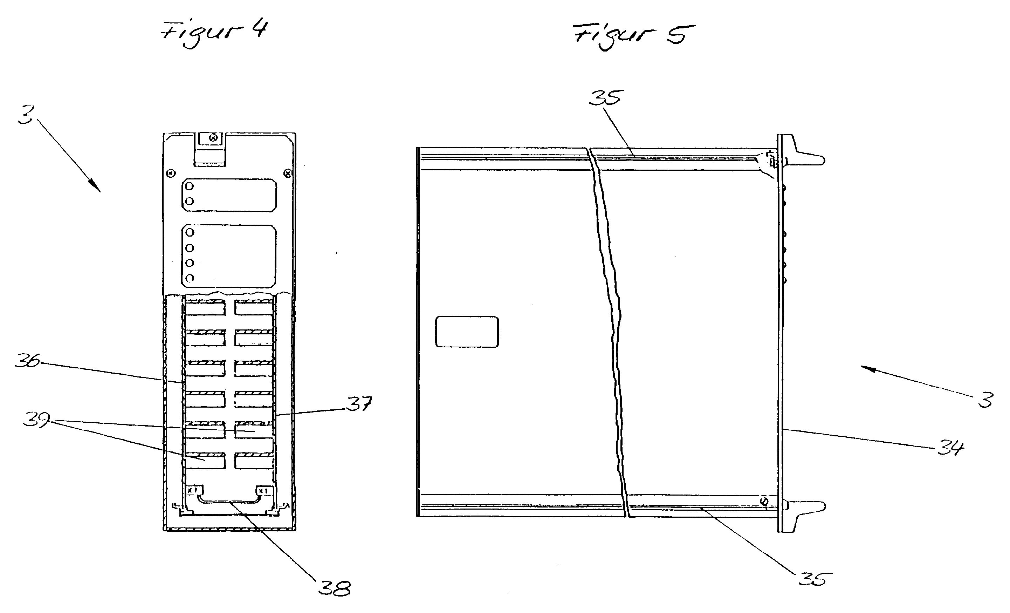

In den Figuren 4 und 5 ist ein Reglereinschub 3 dargestellt, der mit Führungsleisten versehen ist, die in entsprechende Führungsschienen im Gerätegehäuse 1 einführbar sind. Frontseitig ist der Reglereinschub 3 mit einer Frontplatte 34 verschlossen, die auch zum Verschließen der Einschubkammer 2 dient.

Der Reglereinschub 3 weist Einschubführungen 35 auf, in die eine Rechnerplatine 36 und eine Erweiterungsrechnerplatine 37 derart einführbar sind, daß sie senkrecht stehend in einem Abstand voneinander etwa parallel zueinander im Reglereinschub 3 angeordnet sind.

Über ein Flachkabel 38 sind die Rechnerplatine 36 und die Erweiterungsrechnerplatine 37 leitend miteinander verbunden. Beide Platinen 36 und 37 sind mit nicht dargestellten Rechnereinheiten versehen.

Weiterhin tragen die Platinen Steckkontakteinrichtungen, auf die Leiterplatinen 39 elektrisch verbindend aufsteckbar sind. Dabei sind die Leiterplatinen 39 der Rechnerplatine 36 und der Erweiterungsrechnerplatine 37 zueinander gerichtet auf ihren Platinen 36 und 37 angeordnet. Zum senkrechten Durchblasen des Reglereinschubes 3 mit Kühlluft ist dieser in seinem Boden- und Deckelbereich offen.

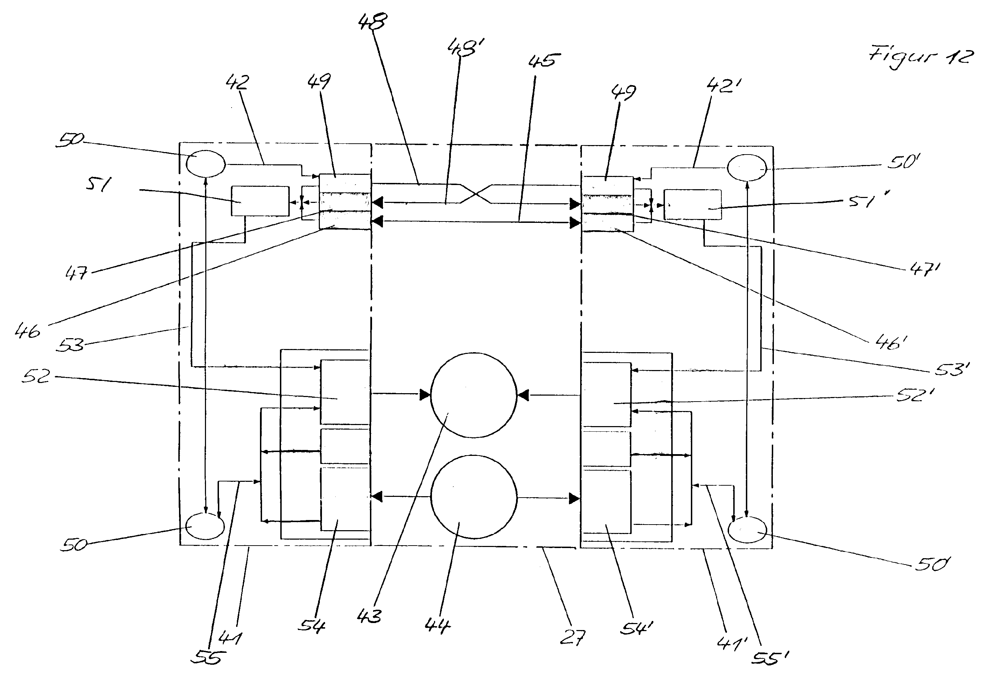

Wie in den Figuren 10 und 11 zu sehen ist besitzt der Netzteileinschub 5 einen etwa gleichen äußeren Aufbau wie der Reglereinschub 3. Seine Frontseite ist durch eine Frontplatte 40 verschlossen und er besitzt ebenfalls Führungsleisten, die in entsprechende Führungsschienen der Einschubkammer 4 einführbar sind. Bei dem in Figur 12 dargestellten Blockschaltbild bildet die mittlere, von einer strichpunktierten Linie umschlossene Einheit die Verbindungsleiterplatte 27 und die beiden äußeren durch strichpunktierte Linien umschlossene Einheiten jeweils eine Reglereinheit 41 und 41′ eines Reglereinschubes 3.

Die Verbindungsleiterplatte 27 ist mit einem Ausgangs-Anschlußkontakt 43 und einem Eingang-Anschlußkontakt 44 versehen.

Über eine Synchronisierleitung 45 sind Synchronisiereinheiten 46 und 46′ der Reglereinheiten 41 und 41′ untereinander verbunden, die für ein synchrones Arbeiten der Reglereinheiten 41 und 41′ sorgen.

Mittels einer nicht dargestellten Selbsttestschaltung überprüfen sich beide Reglereinheiten 41 und 41′ permanent und leiten von ihren Rechnern 50 bzw. 50′ über Testleitungen 42 bzw. 42′ ein entsprechendes Signal einer Reglerstatuseinheit 47 bzw. 47′ zu.

Über Statusleitungen 48 bzw. 48′ werden von den Reglerstatuseinheiten 47 und 47′ jeweils Statussignale zu Statuseinheiten 49′ und 49 geleitet.

Von der Synchronisiereinheit 46 bzw. 46′ , der Reglerstatuseinheit 47 bzw. 47′ und der Statuseinheit 49 bzw. 49′ werden entsprechend ihrer Eingangssignale Signale an eine Statusauswertung 51 bzw. 51′ geleitet.

Sind von den Selbsttestschaltungen keine Fehler festgestellt worden, erhält ein Ausgangsmodul 52 bzw. 52′ einer Reglereinheit 41 bzw. 41′ über eine Ausgangsleitung 53 bzw. 53′ ein Öffnungssignal, so daß das Ausgangsmodul 52 bzw. 52′ von den Rechnern 50 bzw. 50′ erhaltene Informationen dem Ausgangsanschlußkontakt 43 zuleiten kann.

Gleichzeitig erhält das andere Ausgangsmodul 52′ bzw. 52 ein Sperrsignal und kann keine Informationen dem Ausgangsanschlußkontakt 53 zuleiten.

Wird von einer Selbsttestschaltung ein Fehler in einer Reglereinheit 41 bzw. 41′ festgestellt, leitet die Statusauswertung 51 bzw. 51′ dieser Reglereinheit 41 bzw. 41′ ihrem Ausgangsmodul 52 bzw. 52′ ein Sperrsignal zu. Gleichzeitig leitet die Statusauswertung 51′ bzw. 51 der anderen Reglereinheit 41′ bzw. 41 ihrem Ausgangsmodul 52′ bzw. 52 ein Öffnungssignal zu, so daß dieser von dem Rechner 50′ bzw. 50 erhaltene Informationen dem Ausgangsanschlußkontakt 43 zuleiten kann.

Die Eingangsinformationen, die über den Eingangsanschlußkontakt 44 den Eingangsmodulen 54 zugeleitet werden, werden über Eingangsleitungen 55 und 55′ permanent beiden Rechnern 50 und 50′ zugeführt und können dort verarbeitet werden.

## Patentansprüche

1. Gerät zum Erfassen und Verarbeiten von elektrischen Signalen, mit einem Gerätegehäuse, das in zur Frontseite hin offenen Einschubkammern unterteilt ist, wobei in eine Einschubkammer ein eine elektronische Reglereinheit enthaltender Reglereinschub und in eine zweite Einschubkammer ein ein Netzteil enthaltender Netzteileinschub angeordnet ist, wobei die Reglereinheit und das Netzteil mittels Leitungen sowohl untereinander als auch mit Anschlußkontakten für externe Anschlüsse verbunden sind, wobei in weiteren zur Frontseite des Gerätegehäuses (1) offenen Einschubkammern (2) ein Reglereinschub (3) mit einer zur ersten Reglereinheit identischen zweiten elektronischen Reglereinheit und ein Netzteileinschub (5) mit einem zum ersten Netzteil identischen zweiten Netzteil angeordnet sind, die mittels Leitungen sowohl untereinander als auch mit Anschlußkontakten (31) für externe Anschlüsse verbunden sind, wobei durch das erste Netzteil die erste Reglereinheit und durch das zweite Netzteil die zweite Reglereinheit energieversorgbar ist, wobei beiden Reglereinheiten gleichzeitig parallel von außen über die Leitungen die gleichen Eingangssignale zugeleitet und von beiden Reglereinheiten synchron verarbeitet werden und wobei abhängig von der Signalverarbeitung und/oder dem Status der Reglereinheiten ausschließlich von einer der Reglereinheiten Ausgangssignale erzeugt werden.

2. Gerät nach Anspruch 1, dadurch gekennzeichnet, daß Reglereinheiten und Netzteile mit einer im Gerätegehäuse (1) angeordneten Verbindungsleiterplatte (27) verbindbar sind, auf der die Leitungen ausgebildet und die Anschlußkontakte (31) angeordnet sind.

3. Gerät nach Anspruch 2, dadurch gekennzeichnet, daß die Verbindungsleiterplatte (27) die der Frontseite gegenüberliegende Bodenseite der Einschubkammern (2, 4) überdeckt und mit den Leitungen verbundene Gegensteckkontakte (28, 29) aufweist, in die an der Rückseite der Netzteileinschübe (5) und/oder der Reglereinschübe (3) angeordnete Steckkontakte einführbar sind.

4. Gerät nach einem der vorhergehenden Ansprüche 2 oder 3, dadurch gekennzeichnet, daß die Verbindungsleiterplatte (27) über den Bereich der Einschubkammern (2, 4) hinaus in den Bereich einer Kontaktierungskammer (7) erstreckt, die in dem Gerätegehäuse (1) seitlich neben den Einschubkammern (2, 4) angeordnet ist und in deren Bereich die Anschlußkontakte (31) für externe Anschlüsse auf der Verbindungsleiterplatte (27) angeordnet sind.

5. Gerät nach Anspruch 4, dadurch gekennzeichnet, daß die Anschlußkontakte (31) Steckkontakte sind.

6. Gerät nach Anspruch 4, dadurch gekennzeichnet, daß die frontseitige Öffnung (9) der Kontaktierungskammer (7) durch eine Verschlußplatte (8) verschließbar ist.

7. Gerät nach Anspruch 6, dadurch gekennzeichnet, daß die Verschlußplatte (8) um eine sich entlang einer Seitenkante der Öffnung (9) erstreckende Schwenkachse (19) schwenkbar ist.

8. Gerät nach Anspruch 4, dadurch gekennzeichnet, daß der Boden und/oder Deckel des Gerätegehäuses (1) im Bereich der Kontaktierungskammer (7) eine Kabeldurchführöffnung aufweist.

9. Gerät nach Anspruch 4, dadurch gekennzeichnet, daß die den Einschubkammern abgewandte Seitenwand der Kontaktierungskammer (7) eine Kabeldurchführöffnung (33) aufweist.

10. Gerät nach Anspruch 9, dadurch gekennzeichnet, daß die Kabeldurchführöffnung (33) im oberen und/oder unteren Bereich der Seitenwand (32) angeordnet ist.

11. Gerät nach einem der vorhergehenden Ansprüche, dadurch gekennzeichnet, daß die frontseitigen Öffnungen der Einschubkammern (2, 4) durch Frontplatten (34, 40) der Reglereinschübe (3) und/oder Netzteileinschübe (5) verschließbar sind.

12. Gerät nach einem der vorhergehenden Ansprüche, dadurch gekennzeichnet, daß im Gerätegehäuse (1) unter den Einschubkammern (2, 4) eine Lüfterkammer (6) ausgebildet ist, in der eine Lüftereinheit (16) angeordnet ist, durch die von außen angesaugte Luft über Verbindungsöffnungen in die Einschubkammern (2, 4) blasbar ist.

13. Gerät nach Anspruch 12, dadurch gekennzeichnet, daß die Einschubkammern (2, 4) durch ein Lochblech von der Lüfterkammer (6) getrennt sind.

14. Gerät nach Anspruch 12, dadurch gekennzeichnet, daß die Lüftereinheit (16) eine Einschubeinheit ist, die in die Lüfterkammer (6) einschiebbar ist.

15. Gerät nach Anspruch 12, dadurch gekennzeichnet, daß die Lüftereinheit (16) mehrere über die Ebene der Lüfterkammer (6) verteilt angeordnete Lüfter (21) besitzt.

16. Gerät nach Anspruch 15, dadurch gekennzeichnet, daß die Lüfter (21) auf einer gemeinsamen Trägerplatte (15) angeordnet sind.

17. Gerät nach Anspruch 16, dadurch gekennzeichnet, daß die Trägerplatte (15) eine mit der Verbindungsleiterplatte (27) kontaktierbare Leiterplatte ist, auf der ggfs. elektronische Bauteile (23) angeordnet sind.

18. Gerät nach Anspruch 16, dadurch gekennzeichnet, daß die Trägerplatte (15) in Einschubführungen (13) der Lüfterkammer (6) einführbar ist.

19. Gerät nach einem der vorhergehenden Ansprüche 12 bis 18, dadurch gekennzeichnet, daß in der Lüfterkammer (6) auf der den Einschubkammern (2, 4) entgegengesetzten Seite der Lüftereinheit (16) eine Filtereinheit (24) angeordnet ist, über die von der Lüftereinheit (16) Außenluft ansaugbar ist.

20. Gerät nach Anspruch 19, dadurch gekennzeichnet, daß die Filtereinheit (24) einen starren Träger (17) aufweist, der in den den Lüftern (21) gegenüberliegenden Bereichen luftdurchlässige Filterbereiche aufweist.

21. Gerät nach Anspruch 20, dadurch gekennzeichnet, daß der Träger (17) in Führungen (14) geführt in die Lüfterkammer (6) einführbar ist.

22. Gerät nach Anspruch 12, dadurch gekennzeichnet, daß die frontseitige Öffnung (11) der Lüfterkammer (6) von einem Deckel (12) verschließbar ist.

23. Gerät nach Anspruch 12, dadurch gekennzeichnet, daß der Boden der Lüfterkammer (6) durch ein Lochblech gebildet ist.

24. Gerät nach einem der vorhergehenden Ansprüche, dadurch gekennzeichnet, daß der Deckel des Gerätegehäuses (1) im Bereich der Einschubkammern (2, 4) durch ein Lochblech gebildet ist.

25. Gerät nach einem der vorhergehenden Ansprüche, dadurch gekennzeichnet, daß in dem Reglereinschub (3) eine erste eine zentrale Rechnereinheit tragende Rechnerplatine (36) anordenbar ist, die Steckkontakteinrichtungen aufweist, auf die weitere Leiterplatinen (39) elektrisch verbindend aufsteckbar sind.

26. Gerät nach Anspruch 25, dadurch gekennzeichnet, daß in dem Reglereinschub (3) eine zweite eine zentrale Rechnereinheit tragende Erweiterungsrechnerplatine (37) anordenbar ist, die Steckkontakteinrichtungen aufweist, auf die weitere Leiterplatinen (39) elektrisch verbindend aufsteckbar sind.

27. Gerät nach Anspruch 25 oder 26, dadurch gekennzeichnet, daß der Reglereinschub (3) Einschubführungen (35) aufweist, in die die Rechnerplatine (36) und/oder die Erweiterungsrechnerplatine (37) einführbar sind.

28. Gerät nach Anspruch 26, dadurch gekennzeichnet, daß die Rechnerplatine (36) und die Erweiterungsrechnerplatine (37) mittels eines Kabels leitend verbindbar sind.

29. Gerät nach Anspruch 28, dadurch gekennzeichnet, daß das Kabel ein Flachkabel (38) ist.

30. Gerät nach einem der vorhergehenden Ansprüche 25 bis 29, dadurch gekennzeichnet, daß die Rechnerplatine (36) und die Erweiterungsrechnerplatine (37) in einem Abstand etwa parallel zueinander im Reglereinschub (3) anordenbar sind, wobei die Leiterplatinen (39) von Rechnerplatine (36) und Erweiterungsrechnerplatine (37) etwa rechtwinklig wegragend zueinander gerichtet anordenbar sind.

31. Gerät nach einem der vorhergehenden Ansprüche, dadurch gekennzeichnet, daß der Reglereinschub (3) in seinem Boden- und Deckelbereich offen ist.

32. Gerät nach einem der vorhergehenden Ansprüche, dadurch gekennzeichnet, daß die Reglereinheit eine Selbsttestschaltung aufweist, durch die abhängig vom Status der Reglereinheit ein Fehlersignal bzw. ein Gutsignal erzeugbar ist.

33. Gerät nach Anspruch 32, dadurch gekennzeichnet, daß durch ein Fehlersignal einer Reglereinheit der Ausgang dieser Reglereinheit sperrbar ist.

34. Gerät nach Anspruch 32, dadurch gekennzeichnet, daß durch ein Fehlersignal einer Reglereinheit in der anderen Reglereinheit eine Aktivierung auslösbar ist, durch die der Ausgang der anderen Reglereinheit aktivierbar ist.

## Claims

1. An apparatus for detecting and processing electrical signals, having an apparatus housing which is subdivided into insertion chambers which are open towards the front side, with a controller insert containing an electronic controller unit being located in one insertion chamber and a power pack insert containing a power pack being located in a second insertion chamber, the controller unit and the power pack being connected both to each other and to connection contacts for external connections by means of lines, with a controller insert (3) with a second electronic controller unit identical to the first controller unit and a power pack insert (5) with a second power pack identical to the first power pack being located in additional insertion chambers (2) open towards the front side of the apparatus housing (1), which additional inserts are connected both to each other and to connection contacts (31) for external connections by means of lines, with the first controller unit being able to be supplied with energy via the first power pack and the second controller unit by the second power pack, with the same input signals being passed to both controller units simultaneously in parallel from the outside via the lines and being processed synchronously by both controller units, and with output signals being generated exclusively by one of the controller units, dependent on the signal processing and/or the status of the controller units.

2. An apparatus according to Claim 1, characterised in that the controller units and power packs can be connected to a connection printed circuit board (27) located in the apparatus housing (1), on which board the lines are formed and the connection contacts (31) are arranged.

3. An apparatus according to Claim 2, characterised in that the connection printed circuit board (27) covers the base side of the insertion chambers (2, 4) which lies opposite the front side, and has counter-plug contacts (28, 29) connected to the lines, into which contacts plug contacts located on the rear side of the power pack inserts (5) and/or the controller inserts (3) can be introduced.

4. An apparatus according to one of the preceding Claims 2 or 3, characterised in that the connection printed circuit board (27) extends beyond the region of the insertion chambers (2, 4) into the region of a contacting chamber (7) which is located in the apparatus housing (1) laterally next to the insertion chambers (2, 4) and in the region of which the connection contacts (31) for external connections are located on the connection printed circuit board (27).

5. An apparatus according to Claim 4, characterised in that the connection contacts (31) are plug contacts.

6. An apparatus according to Claim 4, characterised in that the front-side opening (9) of the contacting chamber (7) can be closed by a closing plate (8).

7. An apparatus according to Claim 6, characterised in that the closing plate (8) is pivotable about a pivot axis (19) extending along a side edge of the opening (9).

8. An apparatus according to Claim 4, characterised in that the base and/or cover of the apparatus housing (1) has a passage opening for a cable in the region of the contacting chamber (7).

9. An apparatus according to Claim 4, characterised in that the side wall of the contacting chamber (7) which is remote from the insertion chambers has a passage opening (33) for a cable.

10. An apparatus according to Claim 9, characterised in that the passage opening (33) for a cable is located in the upper and/or lower region of the side wall (32).

11. An apparatus according to one of the preceding Claims, characterised in that the front-side openings of the insertion chambers (2, 4) can be closed by front plates (34, 40) of the controller inserts (3) and/or power pack inserts (5).

12. An apparatus according to one of the preceding Claims, characterised in that a blower chamber (6) is formed in the apparatus housing (1) beneath the insertion chambers (2, 4), in which a blower unit (16) is located, through which air drawn in from outside can be blown via connecting openings into the insertion chambers (2, 4).

13. An apparatus according to Claim 12, characterised in that the insertion chambers (2, 4) are separated from the blower chamber (6) by a perforated plate.

14. An apparatus according to Claim 12, characterised in that the blower unit (16) is an insertion unit which can be inserted into the blower chamber (6).

15. An apparatus according to Claim 12, characterised in that the blower unit (16) has a plurality of blowers (21) distributed across the plane of the blower chamber (6).

16. An apparatus according to Claim 15, characterised in that the blowers (21) are located on a common supporting plate (15).

17. An apparatus according to Claim 16, characterised in that the supporting plate (15) is a printed circuit board which can be contacted to the connection printed circuit board (27), on which former board optionally electronic components (23) are arranged.

18. An apparatus according to Claim 16, characterised in that the supporting plate (15) can be introduced into insertion guides (13) of the blower chamber (6).

19. An apparatus according to one of the preceding Claims 12 to 18, characterised in that a filter unit (24) is located in the blower chamber (6) on the side of the blower unit (16) opposite the insertion chambers (2, 4), via which filter unit external air can be drawn in by the blower unit (16).

20. An apparatus according to Claim 19, characterised in that the filter unit (24) has a rigid support (17), which has air-permeable filter regions in the regions lying opposite the blowers (21).

21. An apparatus according to Claim 20, characterised in that the support (17) can be introduced into the blower chamber (6), guided in guides (14).

22. An apparatus according to Claim 12, characterised in that the front-side opening (11) of the blower chamber (6) can be closed by a cover (12).

23. An apparatus according to Claim 12, characterised in that the base of the blower chamber (6) is formed by a perforated plate.

24. An apparatus according to one of the preceding Claims, characterised in that the cover of the apparatus housing (1) in the region of the insertion chambers (2, 4) is formed by a perforated plate.

25. An apparatus according to one of the preceding Claims, characterised in that a first computer board (36) which bears a central computer unit can be arranged in the controller insert (3), which board has plug contact means onto which additional printed circuit boards (39) can be plugged in electrically connecting manner.

26. An apparatus according to Claim 25, characterised in that a second add-on computer board (37) which bears a central computer unit can be arranged in the controller insert (3), which board has plug contact means onto which additional printed circuit boards (39) can be plugged in electrically connecting manner.

27. An apparatus according to Claim 25 or 26, characterised in that the controller insert (3) has insertion guides (35) into which the computer board (36) and/or the add-on computer board (37) can be introduced.

28. An apparatus according to Claim 26, characterised in that the computer board (36) and the add-on computer board (37) can be conductively connected by means of a cable.

29. An apparatus according to Claim 28, characterised in that the cable is a ribbon cable (38).

30. An apparatus according to one of the preceding Claims 25 to 29, characterised in that the computer board (36) and the add-on computer board (37) can be located at a distance approximately parallel to each other in the controller insert (3), the printed circuit boards (39) of the computer board (36) and the add-on computer board (37) being able to be arranged directed at each other projecting approximately at right-angles.

31. An apparatus according to one of the preceding Claims, characterised in that the controller insert (3) is open in its base and cover region.

32. An apparatus according to one of the preceding Claims, characterised in that the controller unit has a self-test circuit, by means of which an error signal or a valid signal can be generated, dependent on the status of the controller unit.

33. An apparatus according to Claim 32, characterised in that the output of this controller unit can be blocked by an error signal of a controller unit.

34. An apparatus according to Claim 32, characterised in that by an error signal of one controller unit an activation means can be triggered in the other controller unit, by means of which the output of the other controller unit can be activated.

## Revendications

1. Appareil pour détecter et traiter des signaux électriques, comportant un boîtier d'appareil divisé en chambres à tiroir ouvertes vers la face frontale, un tiroir de réglage comportant une unité de réglage électronique étant agencé dans une chambre à tiroir et un tiroir à bloc d'alimentation comportant un bloc d'alimentation étant agencé dans une seconde chambre à tiroir, l'unité de réglage et le bloc d'alimentation étant reliés au moyen de liaisons aussi bien ensemble qu'à des contacts de raccordement pour des raccordements externes, de plus un tiroir de réglage (3) comportant une seconde unité de réglage électronique identique à la première unité de réglage et un tiroir à bloc d'alimentation (5) comportant un second bloc d'alimentation identique au premier bloc d'alimentation étant agencés dans d'autres chambres à tiroir (2) ouvertes vers la face frontale du boîtier d'appareil (1), tiroirs qui sont reliés au moyen de liaisons aussi bien ensemble qu'à des contacts de raccordement (31) pour des raccordements externes, la première unité de réglage pouvant être alimentée en énergie par le premier bloc d'alimentation et la seconde unité de réglage pouvant être alimentée en énergie par le second bloc d'alimentation, les mêmes signaux d'entrée étant transmis de façon parallèle de l'extérieur par l'intermédiaire des liaisons simultanément aux deux unités de réglage et étant traités de façon synchrone par les deux unités de réglage, et des signaux de sortie étant engendrés exclusivement par l'une des unités de réglage en dépendance du traitement de signaux et/ou de l'état des unités de réglage.

2. Appareil selon la revendication 1,
caractérisé en ce que les unités de réglage et les blocs d'alimentation peuvent être reliés à une plaque conductrice de liaison (27) agencée dans le boîtier d'appareil (1), sur laquelle sont formées les liaisons et sont agencés les contacts de raccordement (31).

3. Appareil selon la revendication 2,
caractérisé en ce que la plaque conductrice de liaison (27) recouvre la face de fond opposée à la face frontale des chambres à tiroir (2,4) et comporte des contacts de connexion (28,29) reliés aux liaisons, dans lesquels peuvent être insérés des contacts de connexion agencés sur la face arrière des tiroirs à bloc d'alimentation (5) et/ou des tiroirs de réglage (3).

4. Appareil selon l'une des revendications précédentes 2 ou 3,
caractérisé en ce que la plaque conductrice de liaison (27) s'étend au-delà de la zone des chambres à tiroir (2,4) dans la zone d'une chambre à contact (7) agencée dans le boîtier d'appareil (1) latéralement à côté des chambres à tiroir (2,4), et dans la zone de laquelle sont agencés les contacts de raccordement (31) pour des raccordements externes sur la plaque conductrice de liaison (27).

5. Appareil selon la revendication 4,
caractérisé en ce que les contacts de raccordement (31) sont des contacts à fiches.

6. Appareil selon la revendication 4,
caractérisé en ce que l'ouverture (9) sur la face frontale de la chambre à contact (7) peut être fermée par une plaque de fermeture (8).

7. Appareil selon la revendication 6,
caractérisé en ce que la plaque de fermeture (8) peut être pivotée autour d'un axe de pivotement (19) s'étendant le long d'un bord latéral de l'ouverture (9).

8. Appareil selon la revendication 4,
caractérisé en ce que le fond et/ou le couvercle du boîtier d'appareil (1) comportent, dans la zone de la chambre à contact (7), une ouverture de passage de câbles.

9. Appareil selon la revendication 4,
caractérisé en ce que la paroi latérale de la chambre à contact (7) opposée aux chambres à tiroir présente une ouverture de passage de câbles (33).

10. Appareil selon la revendication 9,
caractérisé en ce que l'ouverture de passage de câbles (33) est formée dans la zone supérieure et/ou dans la zone inférieure de la paroi latérale (32).

11. Appareil selon l'une des revendications précédentes,
caractérisé en ce que les ouvertures des chambres à tiroir (2,4) du côté frontal peuvent être fermées par des plaques frontales (34,40) des tiroirs de réglage (3) et/ou des tiroirs à bloc d'alimentation (5).

12. Appareil selon l'une des revendications précédentes,
caractérisé en ce qu'une chambre d'aération (6) est formée dans le boîtier d'appareil (1) au-dessous des chambres à tiroir (2,4), dans laquelle est agencée une unité d'aération (16) par laquelle de l'air aspiré de l'extérieur peut être soufflé par l'intermédiaire d'ouvertures de liaison dans les chambres à tiroir (2,4).

13. Appareil selon la revendication 12,
caractérisé en ce que les chambres à tiroir (2,4) sont séparées de la chambre d'aération (6) par une tôle perforée.

14. Appareil selon la revendication 12,
caractérisé en ce que l'unité d'aération (16) est une unité à tiroir qui peut être introduite dans la chambre d'aération (6).

15. Appareil selon la revendication 12,
caractérisé en ce que l'unité d'aération (16) comporte plusieurs éléments d'aération (21) agencés de façon répartie sur le plan de la chambre d'aération (6).

16. Appareil selon la revendication 15,
caractérisé en ce que les éléments d'aération (21) sont agencés sur une plaque de support commune (15).

17. Appareil selon la revendication 16,
caractérisé en ce que la plaque de support (15) est une plaque conductrice pouvant être mise en contact avec la plaque conductrice de liaison (27), sur laquelle sont agencées le cas échéant des pièces électroniques (23).

18. Appareil selon la revendication 16,
caractérisé en ce que la plaque de support (15) peut être introduite dans des guides d'introduction (13) de la chambre d'aération (6).

19. Appareil selon l'une des revendications précédentes 12 à 18,
caractérisé en ce qu'une unité de filtrage (24) est agencée dans la chambre d'aération (6) sur la face de l'unité d'aération (16), opposée aux chambres à tiroir (2,4), par l'intermédiaire de laquelle de l'air externe peut être aspiré par l'unité d'aération (16).

20. Appareil selon la revendication 19,
caractérisé en ce que l'unité de filtrage (24) comporte un support rigide (17) qui présente dans les zones opposées aux éléments d'aération (21) des zones de filtrage laissant passer l'air.

21. Appareil selon la revendication 20,
caractérisé en ce que le support (17) peut être introduit dans la chambre d'aération (6) en étant guidé sur des guides (14).

22. Appareil selon la revendication 12,
caractérisé en ce que l'ouverture (11) de la chambre d'aération (6) du côté frontal peut être fermée par un couvercle (12).

23. Appareil selon la revendication 12,
caractérisé en ce que le fond de la chambre d'aération (6) est formé d'une tôle perforée.

24. Appareil selon l'une des revendications précédentes,
caractérisé en ce que le couvercle du boîtier d'appareil (1) est formé dans la zone des chambres à tiroir (2,4) par une tôle perforée.

25. Appareil selon l'une des revendications précédentes,
caractérisé en ce que dans le tiroir de réglage (3) peut être agencée une première platine de calcul (36) portant une unité de calcul centrale et comportant des dispositifs de contact à fiches, sur lesquels peuvent être connectées de façon électriquement conductrice d'autres platines conductrices (39).

26. Appareil selon la revendication 25,
caractérisé en ce que dans le tiroir de réglage (3) peut être agencée une seconde platine de calcul supplémentaire (37) portant une unité de calcul centrale et comportant des dispositifs de contact à fiches, sur lesquels peuvent être connectées de façon électriquement conductrice d'autres platines conductrices (39).

27. Appareil selon l'une des revendications 25 ou 26,
caractérisé en ce que le tiroir de réglage (3) comporte des guides d'introduction (35) sur lesquels peuvent être introduites la platine de calcul (36) et/ou la platine de calcul supplémentaire (37).

28. Appareil selon la revendication 26,
caractérisé en ce que la platine de calcul (36) et la platine de calcul supplémentaire (37) peuvent être reliées ensemble de façon conductrice au moyen d'un câble.

29. Appareil selon la revendication 28,
caractérisé en ce que le câble est un câble plat (38).

30. Appareil selon l'une des revendications précédentes 25 à 29,
caractérisé en ce que la platine de calcul (36) et la platine de calcul supplémentaire (37) peuvent être agencées de façon écartée et à peu près parallèlement l'une par rapport à l'autre dans le tiroir de réglage (3), les platines conductrices (39) de la platine de calcul (36) et de la platine de calcul supplémentaire (37) pouvant être agencées en faisant saillie à peu près perpendiculairement et en se faisant face.

31. Appareil selon l'une des revendications précédentes,
caractérisé en ce que le tiroir de réglage (3) est ouvert dans sa zone de fond et de couvercle.

32. Appareil selon l'une des revendications précédentes,
caractérisé en ce que l'unité de réglage présente un circuit de test automatique, par lequel en dépendance de l'état de l'unité de réglage un signal d'erreur ou un signal de bon fonctionnement peut être engendré.

33. Appareil selon la revendication 32,
caractérisé en ce que par un signal d'erreur d'une unité de réglage, la sortie de cette unité de réglage peut être fermée.

34. Appareil selon la revendication 32,
caractérisé en ce que par un signal d'erreur d'une unité de réglage, une activation peut être déclenchée dans l'autre unité de réglage, par laquelle la sortie de l'autre unité de réglage peut être activée.
